# EUROPEAN PATENT APPLICATION

(11) **EP 4 336 547 A1**
(43) Date of publication of application: **13.03.2024**
(21) Application number: 23195291.2
(22) Date of filing: 05.09.2023
(51) Int. Cl.: H01L 21/768, H01L 23/48, H01L 23/528

(54) **INTEGRATED CIRCUIT DEVICES INCLUDING A BACK SIDE POWER DISTRIBUTION NETWORK STRUCTURE AND METHODS OF FORMING THE SAME**

(30) Priority: 06.09.2022 US 202263374620 P; 16.02.2023 US 202318169905
(71) Applicant: Samsung Electronics Co., Ltd., Suwon-si, Gyeonggi-do 16677 (KR)
(72) Inventor: HONG, Wonhyuk, San Jose, CA 95134 (US); BAEK, Jaejik, San Jose, CA 95134 (US); LEE, Jongjin, San Jose, CA 95134 (US); SEO, Kang-Ill, San Jose, CA 95134 (US); JUNG, Myunghoon, San Jose, CA 95134 (US)
(74) Representative: Kuhnen & Wacker Patent- und Rechtsanwaltsbüro PartG mbB

(57) **Abstract**

Integrated circuit devices (1000) and methods of forming the same are provided. The integrated circuit devices (1000) may include a lower insulating structure (181), a transistor on the lower insulating structure (181), the transistor including a source/drain region (126), a power rail structure (174) in the lower insulating structure (181), and a power contact structure (148) that is on the power rail structure (174) and electrically connects the source/drain region (126) to the power rail structure (174). The power contact structure (148) may include a lower portion that is in the power rail structure (174).

## Description

### BACKGROUND

The present disclosure generally relates to the field of integrated circuit devices and, more particularly, to integrated circuit devices including a backside power distribution network (BSPDN) structure.

Various structures of an integrated circuit device and methods of forming the same have been proposed to increase the integration density and/or the operational speed of the integrated circuit device. For example, an integrated circuit device including elements formed in a substrate or on a backside of the substrate has been proposed to simplify the middle-of-line (MOL) portion and/or the back-end-of-line (BEOL) portion of device fabrication. Further, an integrated circuit device including conductors having a low contact resistance has been proposed.

### SUMMARY

An integrated circuit device according to some embodiments includes a lower insulating structure, a transistor on the lower insulating structure, the transistor including a source/drain region, a power rail structure in the lower insulating structure, and a power contact structure that is on the power rail structure and electrically connects the source/drain region to the power rail structure. The power contact structure includes a lower portion that is in the power rail structure.

An integrated circuit device according to some embodiments may include a power rail structure and a transistor and a power contact structure on the power rail structure. The transistor may include a source/drain region, the power contact structure may electrically connect the power rail structure to the source/drain region, and an interface between the power contact structure and the power rail structure may be curved toward the power rail structure.

A method of forming an integrated circuit device, according to some embodiments, includes forming a transistor that includes a source/drain region on an upper surface of a substrate structure, forming a power contact structure electrically connected to the source/drain region, and removing a lower portion of the substrate structure. A lower portion of the power contact structure protrudes from a lower surface of the substrate structure after removing the lower portion of the substrate structure. The method also includes forming a power rail structure on the lower surface of the substrate structure. The lower portion of the power contact structure is in the power rail structure.

### BRIEF DESCRIPTION OF THE DRAWINGS

FIG. 1 is a layout of an integrated circuit device according to some embodiments.
FIGS. 2A and 2B are cross-sectional views of an integrated circuit device taken along the line A-A' and the line B-B', respectively, in FIG. 1 according to some embodiments.
FIGS. 3 through 6 respectively are cross-sectional views of integrated circuit devices taken along the line A-A' in FIG. 1 according to some embodiments.
FIG. 7 is a layout of an integrated circuit device according to some embodiments.
FIGS. 8A and 8B are cross-sectional views of an integrated circuit device taken along the line C-C' and the line D-D', respectively, in FIG. 7 according to some embodiments
FIG. 9 is a flow chart of methods of forming an integrated circuit device according to some embodiments.
FIGS. 10 through 17 are cross-sectional views illustrating methods of forming an integrated circuit device according to some embodiments.

### DETAILED DESCRIPTION

According to some embodiments, an integrated circuit device may include a power contact that has a lower contact resistance with a power rail of a BSPDN structure. The power contact may include a portion provided in the power rail and may have a curved interface with the power rail. Further, in some embodiments, a contact conductor (e.g., a metal layer) of the power contact may contact the power rail without an intervening barrier layer (e.g., a metal nitride layer).

Example embodiments will be described in greater detail with reference to the attached figures.

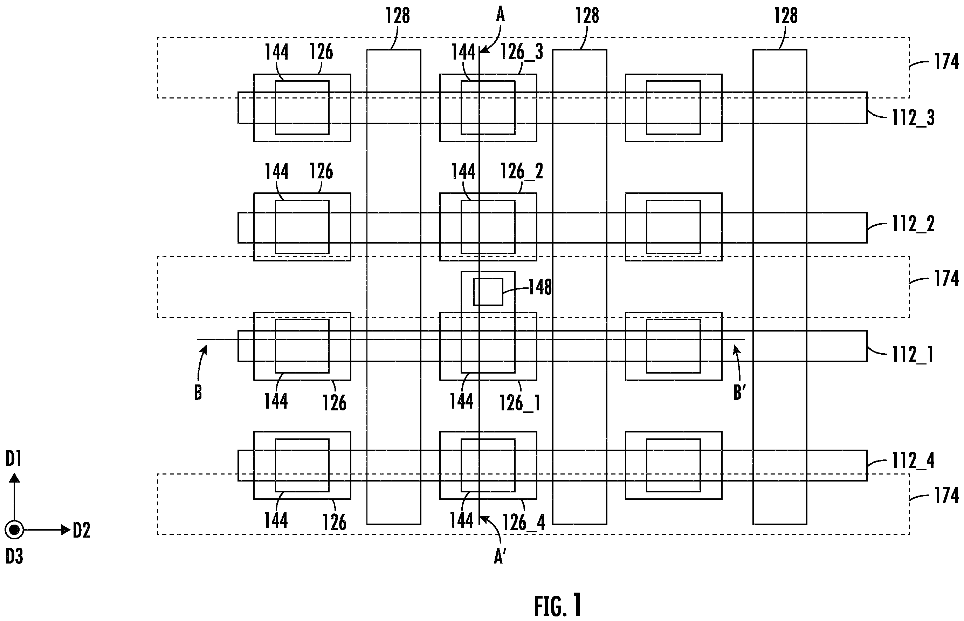

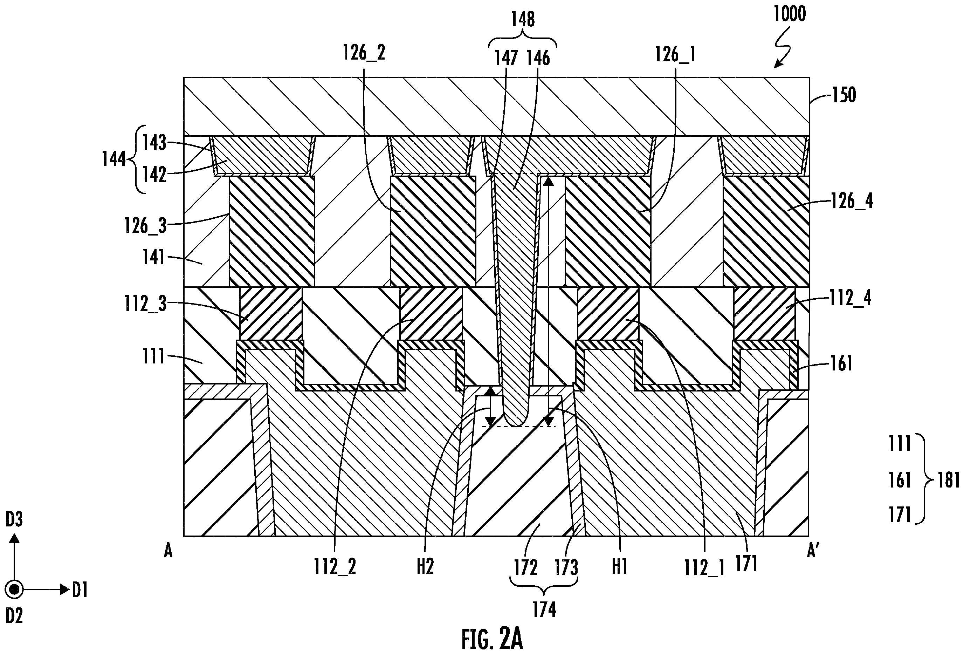

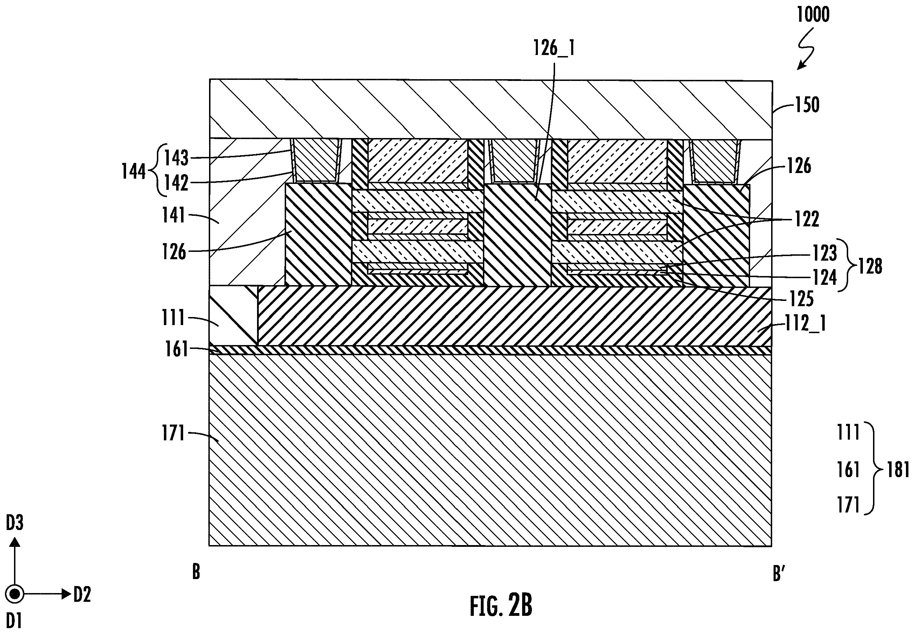

FIG. 1 is a layout of an integrated circuit device according to some embodiments. FIGS. 2A and 2B are cross-sectional views of a first integrated circuit device 1000 taken along the line A-A' and the line B-B', respectively, in FIG. 1 according to some embodiments.

Referring to FIGS. 1, 2A and 2B, the first integrated circuit device 1000 may include transistors on a lower insulating structure 181. The lower insulating structure 181 may include a trench isolation layer 111, an etch stop layer 161, and a backside insulator 171. First, second, third and fourth semiconductor regions 112_1, 112_2, 112_3, 112_4 (also referred to as first, second, third and fourth active regions) may be provided in the lower insulating structure 181 and may be spaced apart from each other in a first direction D1 (also referred to as a first horizontal direction). Adjacent semiconductor regions (e.g., the first and second semiconductor regions 112_1, 112_2) may be separated from each other by a portion of the trench isolation layer 111. The first, second, third and fourth semiconductor regions 112_1, 112_2, 112_3, 112_4 may extend in a second direction D2 (also referred to as a second horizontal direction). As used herein, "an element A extends in a direction X" (or similar language) may mean that the element A extends longitudinally in the direction X.

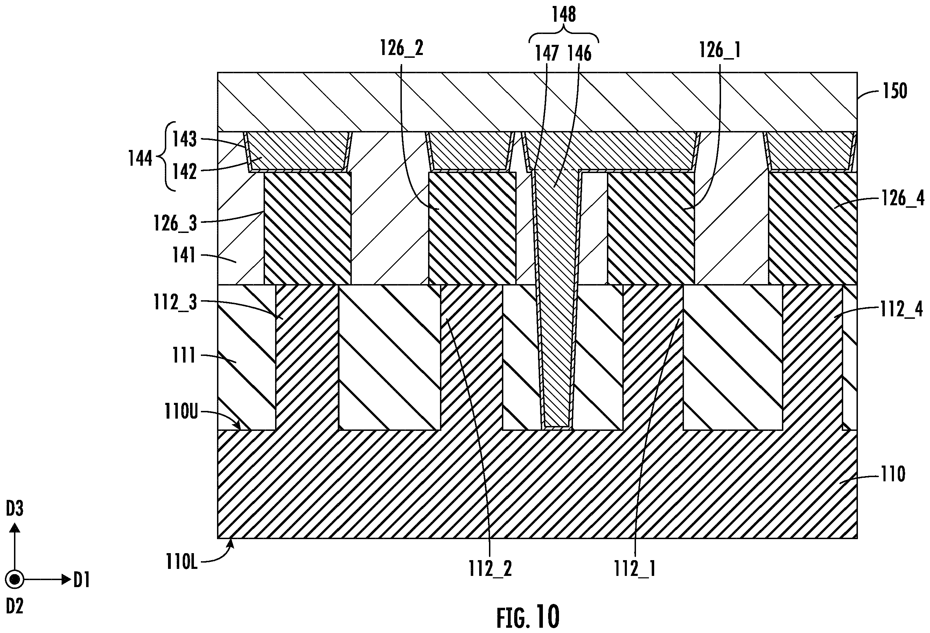

Each of the trench isolation layer 111 and the backside insulator 171 may include an insulating material(s) (e.g., silicon oxide, silicon oxynitride, silicon nitride, silicon carbonitride and/or a low-k material). The low-k material may include, for example, fluorine-doped silicon oxide, organosilicate glass, carbon-doped oxide, porous silicon dioxide, porous organosilicate glass, spin-on organic polymeric dielectrics and/or spin-on silicon based polymeric dielectric. The etch stop layer 161 may include, for example, silicon carbonitride, aluminum nitride, silicon oxynitride and/or silicon nitride. Each of the first, second, third and fourth semiconductor regions 112_1, 112_2, 112_3, 112_4 may be a portion of a substrate (e.g., a substrate 110 in FIG. 10) or may be layers formed using a substrate (e.g., a substrate 110 in FIG. 10) as a seed layer through, for example, an epitaxial growth process. Each of the first, second, third and fourth semiconductor regions 112_1, 112_2, 112_3, 112_4 may include semiconductor material(s), for example, Si, Ge, SiGe, GaP, GaAs, SiC, SiGeC and/or InP.

The transistor may include a gate structure 128 extending in the first direction D1. The gate structure 128 may include a gate insulator 123 and a gate electrode 124. The transistor may also include a channel region 122 that includes opposing side surfaces spaced apart from each other in the second direction D2 and may include source/drain regions 126 respectively on the opposing side surfaces of the channel region 122. The source/drain regions 126 may respectively contact the opposing side surfaces of the channel region 122. The transistor may include multiple channel regions 122 stacked in a third direction D3 (also referred to as a vertical direction). In some embodiments, the transistor may include two channel regions 122 stacked in the third direction D3 as illustrated in FIG. 2B.

The gate insulator 123 may include a silicon oxide layer and/or a high-k material layer. The high-k material layer may include, for example, Al₂O₃, HfO₂, ZrO₂, HfZrO₄, TiOz, Sc₂O₃ Y₂O₃, La₂O₃, Lu₂O₃, Nb₂O₅ and/or Ta₂O₅. The gate electrode 124 may include a metallic layer that includes, for example, tungsten (W), aluminum (Al), copper (Cu), molybdenum (Mo), cobalt (Co) and/or ruthenium (Ru) and may additionally include work function layer(s) (e.g., a TiN layer, a TaN layer, a TiAl layer, a TiC layer, a TiAlC layer, a TiAlN layer and/or a WN layer).

The channel region 122 may include semiconductor material(s) (e.g., Si, Ge, SiGe, GaP, GaAs, SiC, SiGeC and/or InP). In some embodiments, the channel region 122 may be a nanosheet that may have a thickness in a range of from 1 nm to 100 nm in the third direction D3 or may be a nanowire that may have a circular cross-section with a diameter in a range of from 1 nm to 100 nm. The source/drain region 126 may include a semiconductor layer (e.g., a silicon layer and/or a silicon germanium layer) and may additionally include dopants in the semiconductor layer. In some embodiments, each of the source/drain regions 126 may include a metallic layer that includes, for example, W, Al, Cu, Mo and/or Ru.

An insulating spacer 125 (also referred to as a gate spacer or an inner gate spacer) may be provided between the gate structure 128 and the source/drain region 126 to separate the gate structure 128 from the source/drain region 126. A portion of the insulating spacer 125 may also be provided between the semiconductor region (e.g., the first semiconductor region 112_1) and the gate structure 128. The insulating spacer 125 may include, for example, silicon oxide, silicon oxynitride, silicon nitride, silicon carbonitride and/or a low-k material.

A source/drain contact 144 may be provided on the source/drain region 126. The source/drain region 126 may include a lower surface facing the semiconductor region and an upper surface opposite the lower surface of the semiconductor region. The source/drain contact 144 may contact the upper surface of the source/drain region 126. The source/drain contact 144 may include a source/drain conductor 142 and a source/drain barrier layer 143 extending on a side surface of the source/drain conductor 142. In some embodiments, the source/drain barrier layer 143 may extend on a lower surface of the source/drain conductor 142, and the source/drain barrier layer 143 may contact the upper surface of the source/drain region 126, as illustrated in FIGS. 2A and 2B. As used herein, "a lower surface" refers to a surface facing the semiconductor region, and "an upper surface" refers to a surface opposite the lower surface. Further, as used herein, "a lower portion" refers to a portion that is closer than "an upper portion" to the semiconductor region.

An interlayer 141 may be provided on the lower insulating structure 181, and the source/drain regions 126 and the source/drain contacts 144 may be provided in the interlayer 141. A lower surface of the interlayer 141 may contact an upper surface of the trench isolation layer 111. The interlayer 141 may include an insulating material(s) (e.g., silicon oxide, silicon oxynitride, silicon nitride, silicon carbonitride and/or a low-k material).

The first integrated circuit device 1000 may further include a power contact structure 148 that is electrically connected to the source/drain region (e.g., a first source/drain region 126_1). The power contact structure 148 may contact a lower surface of the source/drain contact 144 and may be electrically connected to the source/drain region 126 through the source/drain contact 144. The power contact structure 148 may include a contact conductor 146 and a contact barrier layer 147 extending on a side surface of the contact conductor 146. In some embodiments, the contact conductor 146 and the source/drain conductor 142 may include the same material or may be portions of a single layer, and thus an interface (marked with a dotted line in FIG. 2A) between the contact conductor 146 and the source/drain conductor 142 may not be visible. The power contact structure 148 may include a portion in the interlayer 141 and may extend through the trench isolation layer 111 in the third direction D3.

A power rail structure 174 may be provided in the lower insulating structure 181. The power rail structure 174 may extend in the second direction D2. The power rail structure 174 may include a rail conductor 172 and a rail barrier layer 173 extending on a side surface of the rail conductor 172. The rail barrier layer 173 may also be provided on an upper surface of the rail conductor 172, as illustrated in FIG. 2A. The backside insulator 171 and the power rail structure 174 may be collectively referred to as a BSPDN structure.

The power contact structure 148 may be provided on the power rail structure 174 and may electrically connect the power rail structure 174 to the source/drain region 126. The power contact structure 148 may extend through the rail barrier layer 173, and a lower portion of the power contact structure 148 may be provided in the power rail structure 174 and may contact the power rail structure 174. The power contact structure 148 may have a first height H1 in the third direction D3, the lower portion of the power contact structure 148 may have a second height H2 in the third direction D3, and the second height H2 may be from 1% to 20% (e.g., about 2%, 3%, 4%, 5%, 10%, 15% or 20%) of the first height H1. In some embodiments, a width of the power contact structure 148 in the first direction D1 may increase as a distance from the power rail structure 174 increases, as illustrated in FIG. 2A.

Each of the source/drain conductor 142, the contact conductor 146 and the rail conductor 172 may include a metallic layer including, for example, W, Co, Mo, Ru, Al and/or Cu. In some embodiments, each of the source/drain conductor 142 and the contact conductor 146 may include a Co layer and/or a W layer, and the rail conductor 172 may include a Cu layer. Each of the source/drain barrier layer 143, the contact barrier layer 147, and the rail barrier layer 173 may include a metal nitride layer (e.g., a TiN layer or a TaN layer) and/or a metal layer (e.g., a Ti layer or a Ta layer). In some embodiments, each of the source/drain barrier layer 143 and the contact barrier layer 147 may include a Ti layer and a TiN layer, and the rail barrier layer 173 may include a Ta layer and a TaN layer.

In some embodiments, the lower portion of the power contact structure 148 may have a convex surface, as illustrated in FIG. 2A, and an interface between the power contact structure 148 and the power rail structure 174 may be convexly curved toward the power rail structure 174. In some embodiments, the lower portion of the power contact structure 148 may not be convex. The lower portion of the power contact structure 148 may not include the contact barrier layer 147, and thus the contact conductor 146 may contact the power rail structure 174. In some embodiments, the contact conductor 146 may contact the rail conductor 172.

The first integrated circuit device 1000 may further include a BEOL structure 150 that is formed through the BEOL portion of device fabrication. The BEOL structure 150 may be formed on the source/drain contacts 144. The source/drain contact 144 may electrically connect the source/drain region 126 to a conductive element (e.g., a conductive wire or a conductive via plug) of the BEOL structure 150.

The BEOL structure 150 may include a BEOL insulating layer, conductive wires (e.g., metal wires) that are provided in the BEOL insulating layer and are stacked in the third direction D3, and conductive via plugs (e.g., metal via plugs), each of which may electrically connect two conductive wires that are spaced apart from each other in the third direction D3.

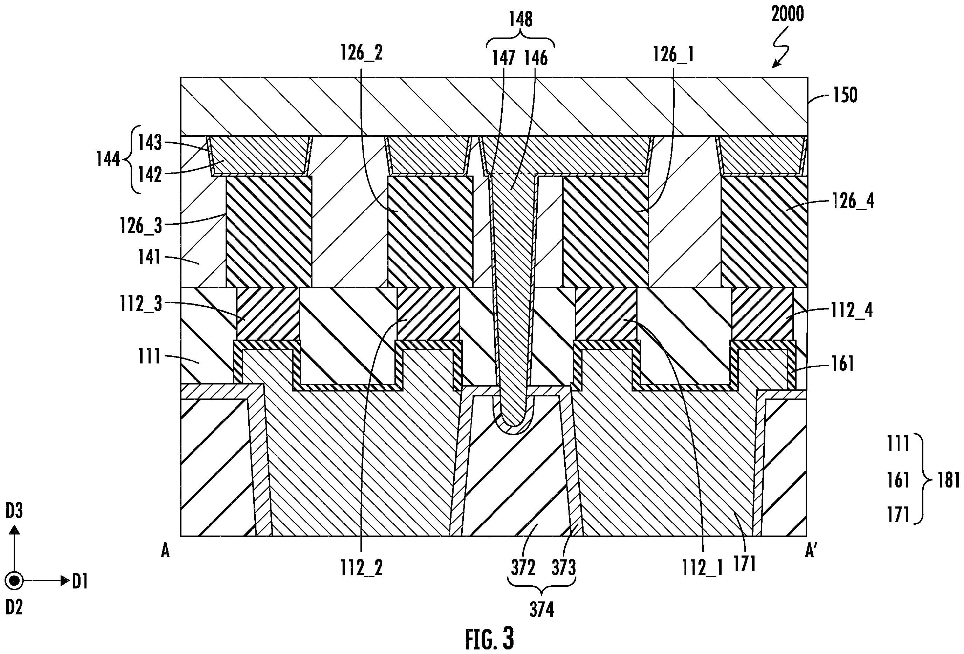

FIG. 3 is a cross-sectional view of a second integrated circuit device 2000, taken along the line A-A' in FIG. 1, according to some embodiments. The second integrated circuit device 2000 is similar to the first integrated circuit device 1000. The second integrated circuit device 2000 may be different from the first integrated circuit device 1000, in that the rail barrier layer 373 may separate the lower portion of the power contact structure 148 from the rail conductor 372. The rail barrier layer 373 may cover and contact the convex surface of the contact conductor 146.

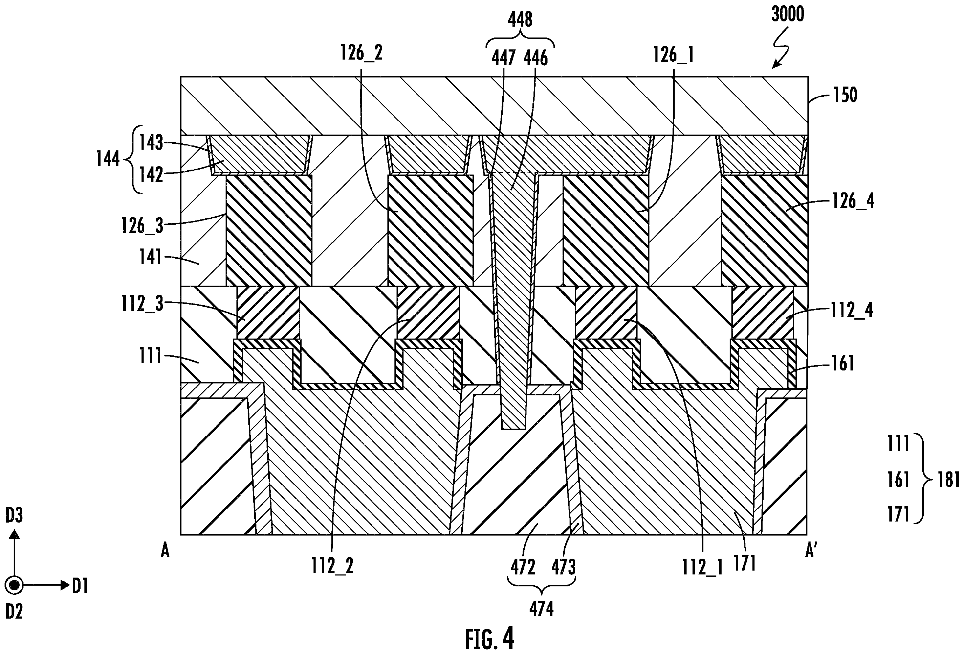

FIG. 4 is a cross-sectional view of a third integrated circuit device 3000, taken along the line A-A' in FIG. 1, according to some embodiments. The third integrated circuit device 3000 is similar to the first integrated circuit device 1000. The third integrated circuit device 3000 may be different from the first integrated circuit device 1000, in that a lower portion of the power contact structure 448 (i.e., a lower portion of the contact conductor 446) provided in the power rail structure 474 may have a flat lower surface and sharp opposing corners.

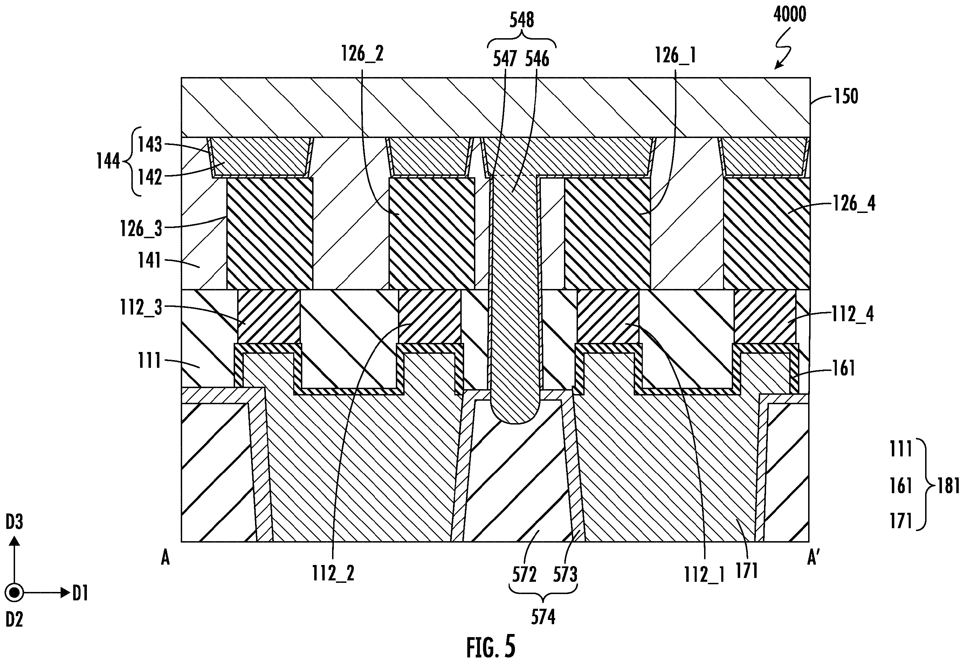

FIG. 5 is a cross-sectional view of a fourth integrated circuit device 4000, taken along the line A-A' in FIG. 1, according to some embodiments. The fourth integrated circuit device 4000 is similar to the first integrated circuit device 1000. The fourth integrated circuit device 4000 may be different from the first integrated circuit device 1000, in that a width of the power contact structure 548 in the first direction D1 may decrease as a distance from the power rail structure 574 increases.

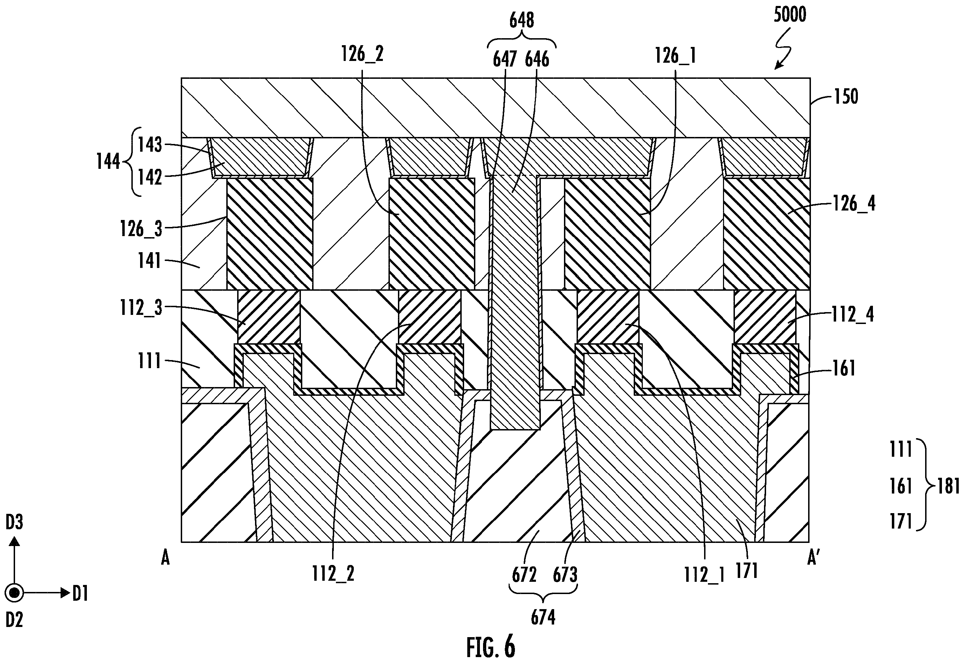

FIG. 6 is a cross-sectional view of a fifth integrated circuit device 5000, taken along the line A-A' in FIG. 1, according to some embodiments. The fifth integrated circuit device 5000 is similar to the fourth integrated circuit device 4000. The fifth integrated circuit device 5000 may be different from the fourth integrated circuit device 4000, in that a lower portion of the power contact structure 648 (i.e., a lower portion of the contact conductor 646) provided in the power rail structure 674 may have a flat lower surface and sharp opposing corners.

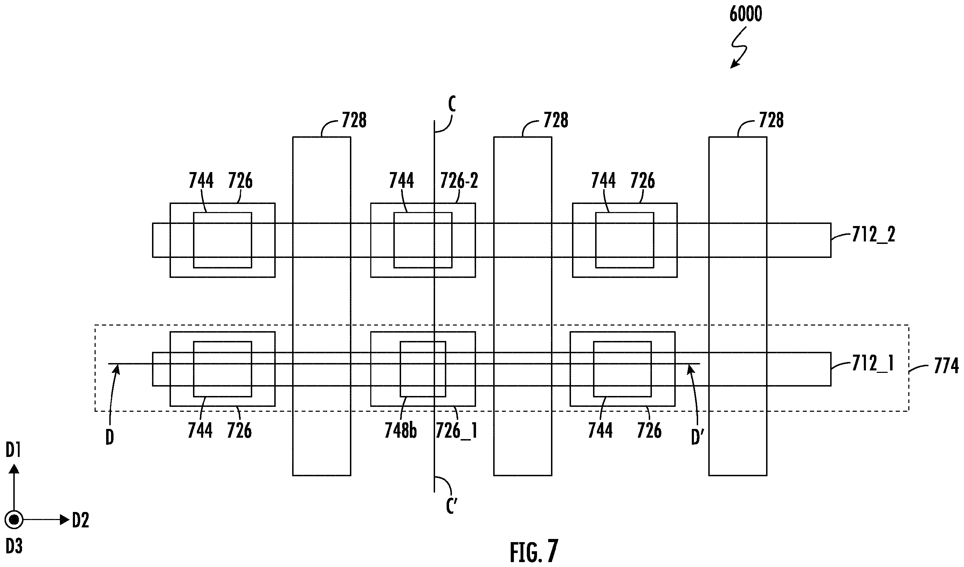

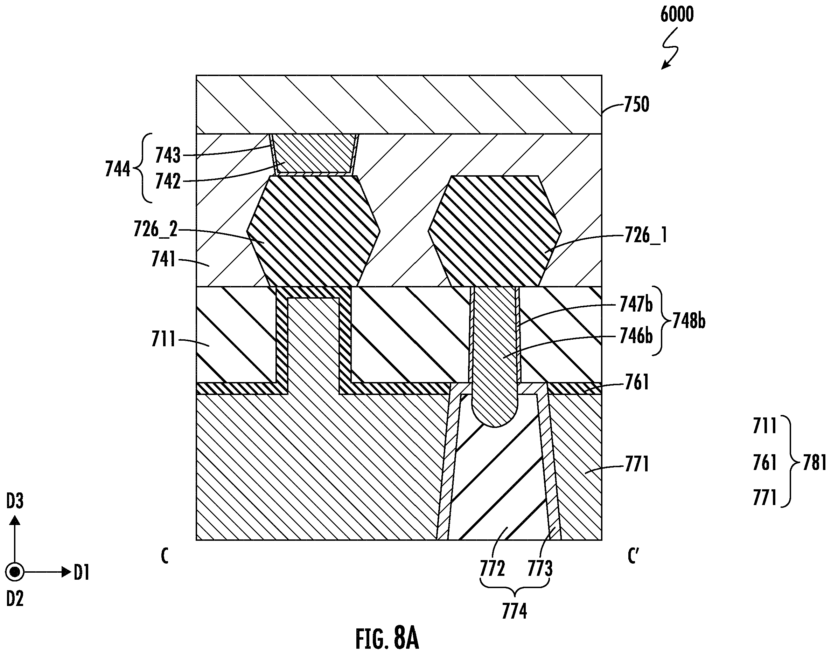

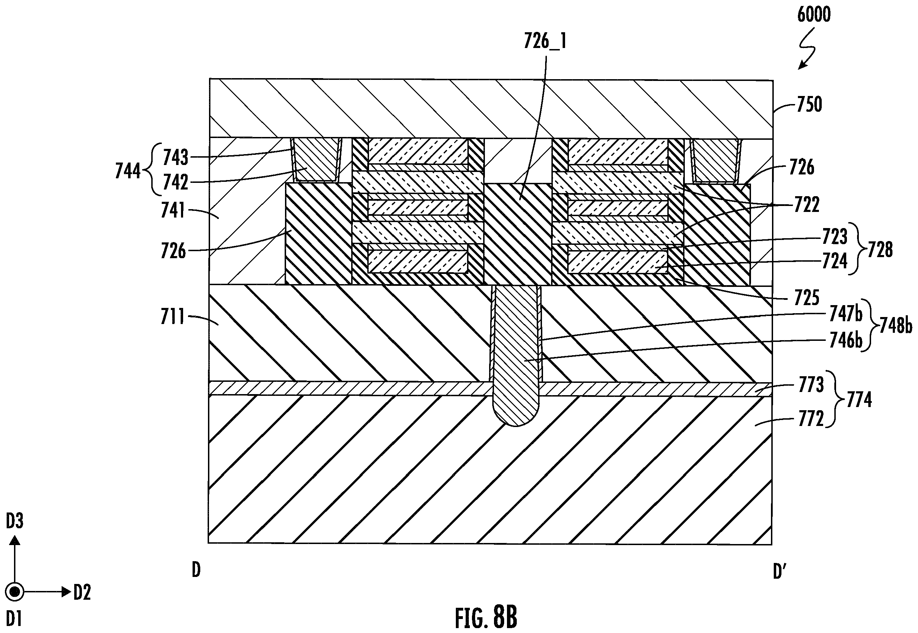

FIG. 7 is a layout of a sixth integrated circuit device 6000 according to some embodiments, and FIGS. 8A and 8B are cross-sectional views taken along the line C-C' and the line D-D', respectively, in FIG. 7, according to some embodiments. The sixth integrated circuit device 6000 is similar to the first integrated circuit device 1000. The sixth integrated circuit device 6000 may be different from the first integrated circuit device 1000, in that a power rail structure 774 may overlap the first semiconductor region 712_1 in the third direction D3, and a power contact structure 748b (also referred to as a buried power contact structure) may contact both the first source/drain region 726_1 and the power rail structure 774. As used herein, "an element A overlapping an element B in a direction X" (or similar language) means that there is at least one line that extends in the direction X and intersects both the elements A and B.

Referring to FIGS. 8A and 8B, the power contact structure 748b may contact a lower surface of the first source/drain region 726_1 and may extend through the trench isolation layer 711. The power contact structure 748b may include a contact conductor 746b and a contact barrier layer 747b on a side surface of the contact conductor 746b. A lower portion of the power contact structure 748b may extend through a rail barrier layer 773 and may be provided in the power rail structure 774. The lower portion of the power contact structure 748b may have a convex surface. The lower portion of the power contact structure 748b may not include contact barrier layer 747b thereon, and thus the contact conductor 746b may contact a rail conductor 772. In some embodiments, a width of the power contact structure 748b in the first direction D1 and/or the second direction D2 may decrease as a distance from the power rail structure 774 increases.

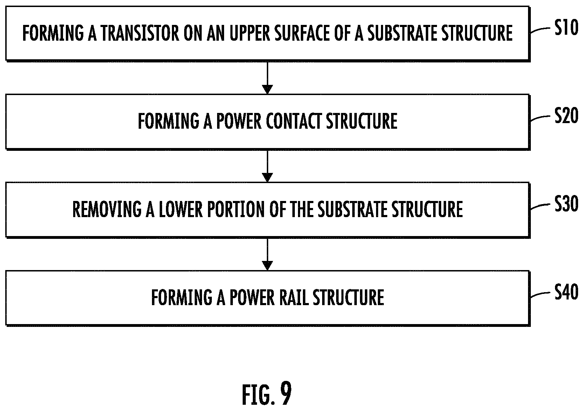

FIG. 9 is a flow chart of methods of forming the first integrated circuit device 1000 according to some embodiments, and FIGS. 10 through 17 are cross-sectional views illustrating those methods according to some embodiments.

Referring to FIGS. 9 and 10, the methods may include forming a transistor on a substrate structure (Block S10). The transistor may include a source/drain region 126 (e.g., a first source/drain region 126_1). The transistor may be formed on an upper surface of the substrate structure. The substrate structure may include a substrate 110, first, second, third and fourth semiconductor regions 112_1, 112_2, 112_3, 112_4 protruding from an upper surface 110U of the substrate 110, and a trench isolation layer 111 provided between the first, second, third and fourth semiconductor regions 112_1, 112_2, 112_3, 112_4. The substrate 110 may include a lower surface 110L that is opposite the upper surface 110U. An interlayer 141 may be formed between source/drain regions 126 (e.g., second, third and fourth source/drain regions 126_2, 126_3, 126_4), and source/drain contacts 144 and a BEOL structure 150 may be formed on the transistor.

The substrate 110 may include semiconductor material(s), for example, Si, Ge, SiGe, GaP, GaAs, SiC, SiGeC and/or InP or may include insulating material(s), for example, silicon oxide, silicon oxynitride, silicon nitride, silicon carbonitride and/or a low-k material. In some embodiments, the substrate 110 may be a bulk substrate (e.g., a bulk silicon substrate) or a semiconductor on insulator (SOI) substrate. For example, the substrate 110 may be a silicon wafer or may be a single insulating layer.

A power contact structure 148 may be formed (Block S20). The power contact structure 148 may be electrically connected to the first source/drain region 126_1. In some embodiments, the power contact structure 148 may be electrically connected to the first source/drain region 126_1 through a source/drain contact 144. The power contact structure 148 may extend through the trench isolation layer 111 in the third direction D3. In some embodiments, the power contact structure 148 may be formed before forming the source/drain contacts 144.

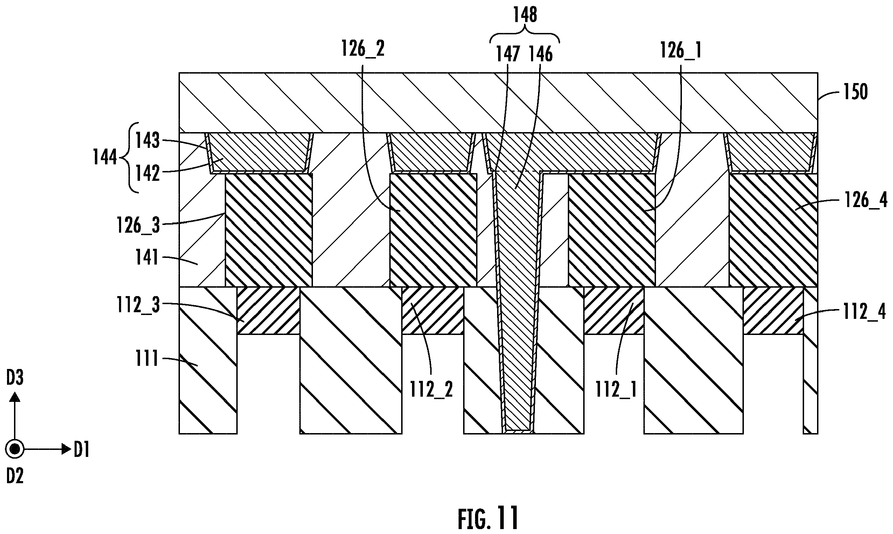

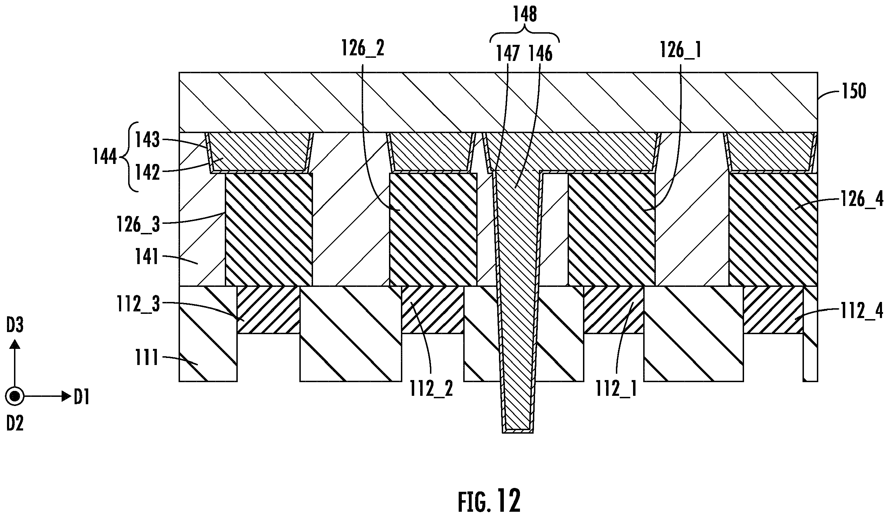

Referring to FIGS. 11 and 12, a lower portion of the substrate structure may be removed (Block S30). In some embodiments, a lower portion of the substrate 110 and lower portions of the first, second, third and fourth semiconductor regions 112_1, 112_2, 112_3, 112_4 may be removed, as illustrated in FIG. 11. The lower portion of the substrate 110 may be removed by performing process(es) (e.g., a grinding process and/or an etch process) on the lower surface 110L of the substrate 110. The lower portions of the first, second, third and fourth semiconductor regions 112_1, 112_2, 112_3, 112_4 may be removed by an etch process (e.g., a dry etch process and/or a wet etch process).

A lower portion of the trench isolation layer 111 may be removed such that a lower portion of the power contact structure 148 may protrude from a lower surface of the substrate structure (i.e., a lower surface of the trench isolation layer 111) and may be exposed, as illustrated in FIG. 12.

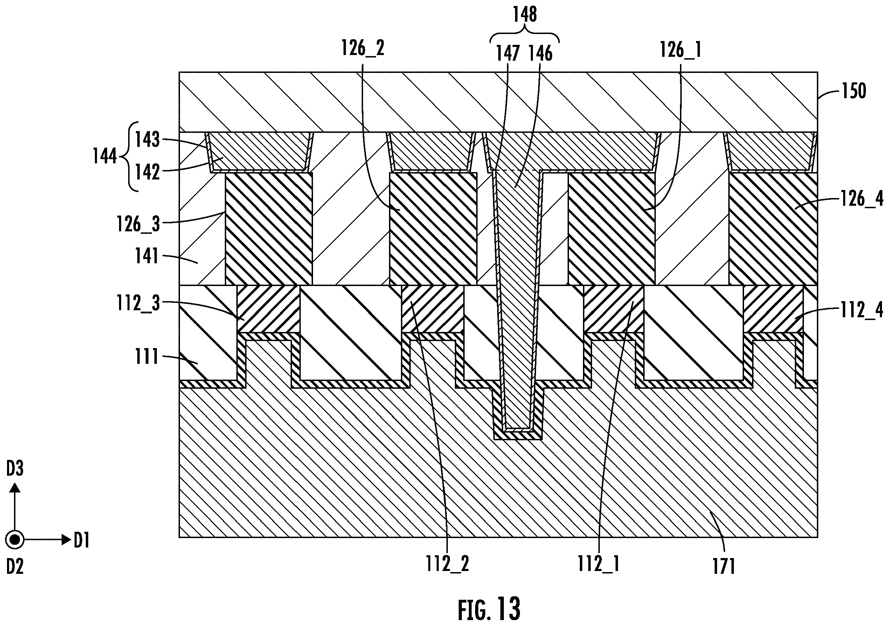

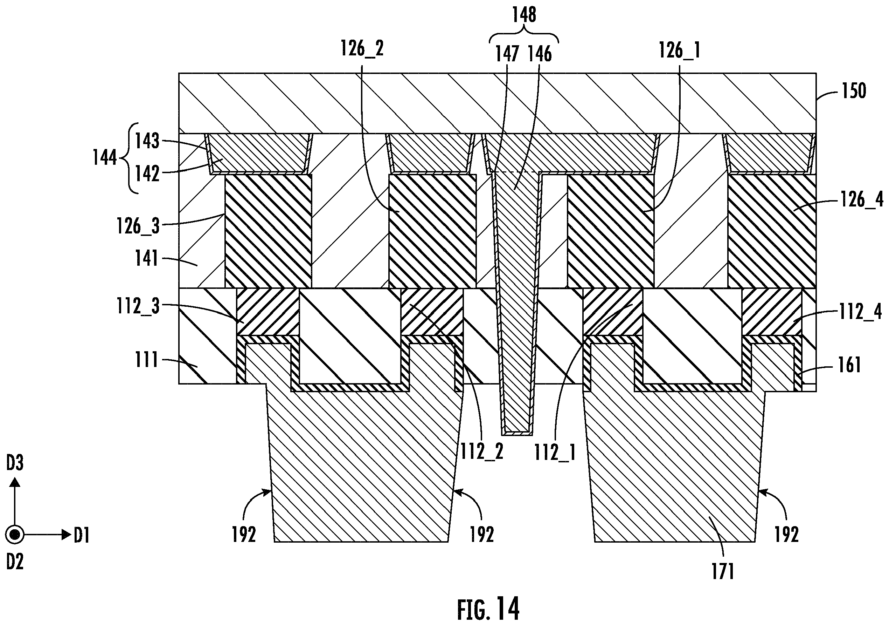

Referring to FIGS. 13 thorough 17 and referring back to FIG. 2A, a power rail structure may be formed (Block S40). Referring to FIG. 13, an etch stop layer 161 and a backside insulator 171 may be sequentially formed on the power contact structure 148. Referring to FIG. 14, portions of the etch stop layer 161 and the backside insulator 171 may be removed to form openings 192 and to expose a lower portion of the power contact structure 148. A lower portion of the contact barrier layer 147 may be removed such that a lower portion of the contact conductor 146 may be exposed to the opening 192.

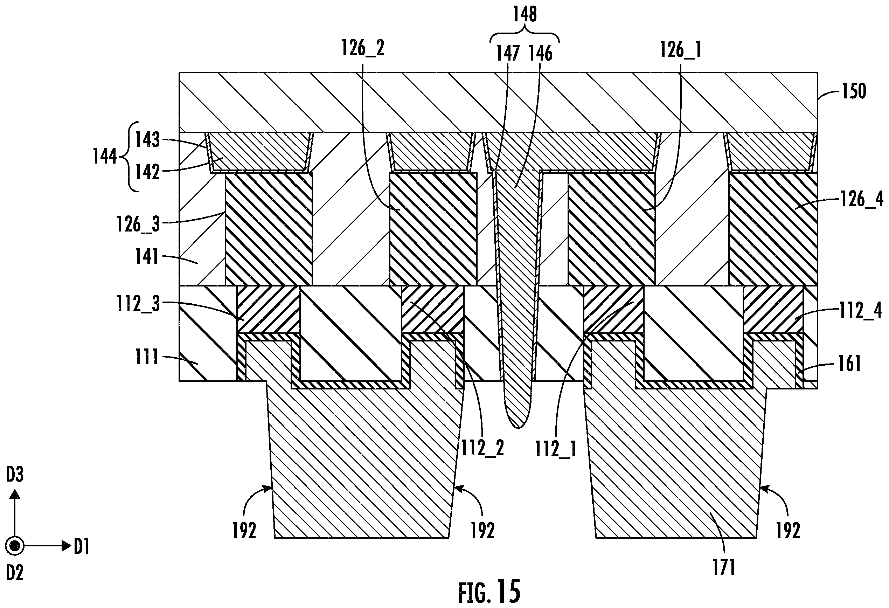

Referring to FIG. 15, a cleaning process (e.g., a hydrogen plasma treatment) may be performed on the exposed lower portion of the contact conductor 146 to clean the exposed lower portion of the contact conductor 146. An oxide layer (e.g., a native oxide layer) formed on the exposed lower portion of the contact conductor 146 may be removed by the cleaning process. Accordingly, the cleaning process may also be referred to as a reduction process. The cleaning process may round the exposed lower portion of the contact conductor 146, and thus the lower portion of the contact conductor 146 may have a convex surface after the cleaning process.

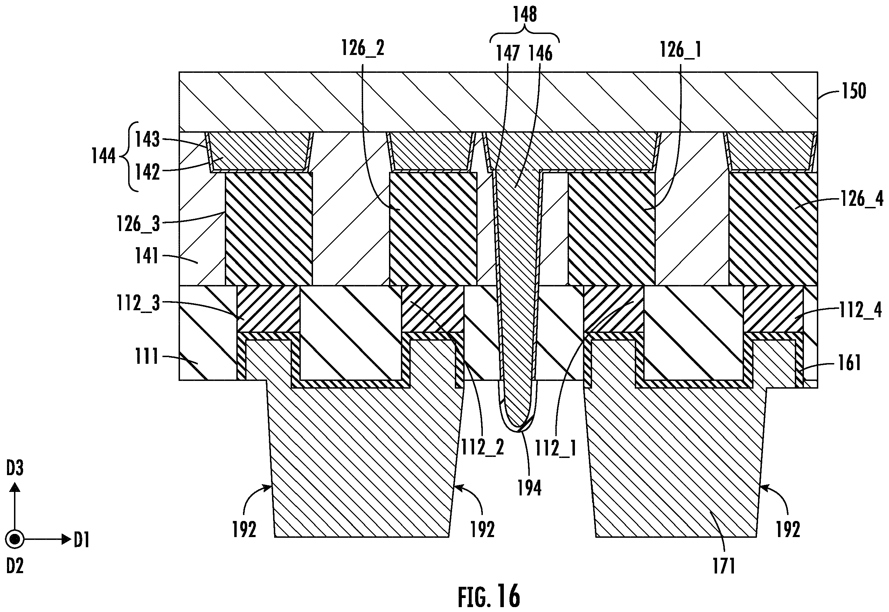

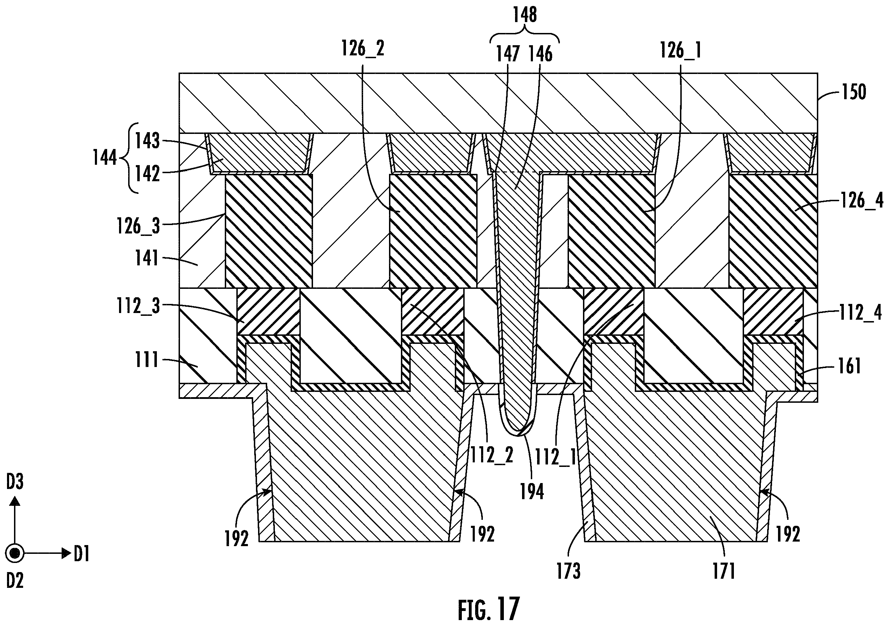

Referring to FIG. 16, a deposition inhibition layer 194 may be formed on the lower portion of the contact conductor 146. The deposition inhibition layer 194 may inhibit deposition of a barrier layer (e.g., a rail barrier layer 173 in FIG. 17). The deposition inhibition layer 194 may be, for example, a self-assembled layer, and may be a monolayer. The self-assembled layer may include, for example, a head group (e.g., thiols, silanes and/or phosphonates) and a tail group. The deposition inhibition layer 194 may be selectively formed on a conductor (e.g., the contact conductor 146) and may not be formed on an insulator (e.g., the trench isolation layer 111 and the backside insulator 171). The deposition inhibition layer 194 may have a uniform thickness along a surface of the lower portion of the contact conductor 146, as illustrated in FIG. 16.

Referring to FIG. 17, a rail barrier layer 173 may be formed in the openings 192. The rail barrier layer 173 may not be formed on the deposition inhibition layer 194 (e.g., a lower portion of the deposition inhibition layer 194) and/or may be formed only on a surface of an insulator (e.g., the trench isolation layer 111 and the backside insulator 171). Referring back to FIG. 2A, the deposition inhibition layer 194 may be removed after the rail barrier layer 173 is formed, and then a rail conductor 172 may be formed in the openings 192 on the rail barrier layer 173.

It will be understood that the second, third, fourth, fifth and sixth integrated circuit devices 2000, 3000, 4000, 5000 and 6000 can be formed by methods similar to those described with reference to FIGS. 10-17 with appropriate modification thereto. For example, the second integrated circuit device 2000 may be formed by omitting the formation of the deposition inhibition layer 194, which is described with reference to FIG. 16, and the third and fifth integrated circuit devices 3000 and 5000 may be formed by omitting the cleaning process that is described with reference to FIG. 15. Throughout the specification, like elements (e.g., the element 173 in FIG. 2A and the 373 in FIG. 3) have the same last two digits of their reference numbers and have the same name.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing. Although an element is illustrated as a single layer in the drawings, that element may include multiple layers.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

## Claims

1. An integrated circuit device (1000) comprising:
a lower insulating structure (181);
a transistor on the lower insulating structure (181), the transistor comprising a source/drain region (126);
a power rail structure (174) in the lower insulating structure (181); and
a power contact structure (148) that is on the power rail structure (174) and electrically connects the source/drain region (126) to the power rail structure (174),
wherein the power contact structure (148) comprises a lower portion that is in the power rail structure (174).

2. The integrated circuit device (1000) of Claim 1, wherein the power contact structure (148) comprises a contact conductor (146) and a contact barrier layer (147) on an outer surface of the contact conductor (146), and
the lower portion of the power contact structure (148) is devoid of the contact barrier layer (147).

3. The integrated circuit device (1000) of Claim 2, wherein the contact barrier layer (147) comprises a metal nitride layer.

4. The integrated circuit device (1000) of Claim 2 or 3, wherein a portion of the contact conductor (146) in the power rail structure (174) contacts the power rail structure (174).

5. The integrated circuit device (1000) of any one of the previous claims, wherein the lower portion of the power contact structure (148) has a convex surface and/or an interface between the power contact structure and the power rail structure is curved toward the power rail structure.

6. The integrated circuit device (1000) of any one of the previous claims, further comprising a first active region (112_1) and a second active region (112_2) in the lower insulating structure (181),
wherein the source/drain region (126) is on the first active region (112_1),
a portion of the lower insulating structure (181) separates the first active region (112_1) from the second active region (112_2), and
the power contact structure (148) extends through the portion of the lower insulating structure (181).

7. The integrated circuit device (1000) of Claim 6, wherein the first and second active regions (112_1, 112_2) are spaced apart from each other in a first direction (D1), and
the power rail structure (174) extends in a second direction (D2) that is perpendicular to the first direction (D1).

8. The integrated circuit device (1000) of Claim 6 or 7, wherein the source/drain region (126) comprises a lower surface facing the first active region (112_1) and an upper surface opposite the lower surface, and
the integrated circuit device (1000) further comprises a source/drain contact (144) that contacts the upper surface of the source/drain region (126) and the power contact structure (148).

9. The integrated circuit device (6000) of any one of claims 1 to 7, wherein the source/drain region (726) comprises a lower surface facing the lower insulating structure (781) and an upper surface opposite the lower surface, and
the power contact structure (748) contacts the lower surface of the source/drain region (726).

10. The integrated circuit device (1000) of any one of the previous claims, further comprising a back-end-of-line, BEOL, structure (150) including a conductive wire on the transistor,
wherein the transistor is between the BEOL structure (150) and the power rail structure (174).

11. A method of forming an integrated circuit device (1000), the method comprising:
forming (S10) a transistor comprising a source/drain region (126) on an upper surface (110U) of a substrate structure (110);
forming (S20) a power contact structure (148) electrically connected to the source/drain region (126);
removing (S30) a lower portion of the substrate structure (110), wherein a lower portion of the power contact structure (148) protrudes from a lower surface (110L) of the substrate structure (110) after removing the lower portion of the substrate structure (110); and then
forming (S40) a power rail structure (174) on the lower surface (110L) of the substrate structure (110), wherein the lower portion of the power contact structure (148) is in the power rail structure (174).

12. The method of Claim 11, wherein the lower portion of the power contact structure (148) has a convex surface.

13. The method of Claim 11 or 12, wherein the power contact structure (148) comprises a contact conductor (146) and a contact barrier layer (147) that extends on a side and a lower surface of the contact conductor (146), and
the method further comprises exposing a lower portion of the contact conductor (146) by removing a lower portion of the contact barrier layer (147) before forming the power rail structure (174), and the lower portion of the contact conductor (146) contacts the power rail structure (174).

14. The method of Claim 13, further comprising rounding a surface of the lower portion of the contact conductor (146) after exposing the lower portion of the contact conductor (146) and before forming the power rail structure (174).

15. The method of Claim 14, wherein forming the power rail structure (174) comprises:
forming a deposition inhibition layer on the rounded surface of the lower portion of the contact conductor (146);
forming a rail barrier layer (173) on the lower surface (110L) of the substrate structure (110), wherein the rail barrier layer (173) is not formed on the deposition inhibition layer;
removing the deposition inhibition layer, thereby exposing the rounded surface of the lower portion of the contact conductor (146); and then
forming a rail conductor (172) on the rail barrier layer (173), wherein the rail conductor (172) contacts the rounded surface of the lower portion of the contact conductor (146).

16. The method of any one of Claims 11 to 15, further comprising, before removing the lower portion of the substrate structure (110), forming a back-end-of-line, BEOL, structure including a conductive wire on the transistor.
